# EUROPEAN PATENT SPECIFICATION

(11) **EP 4 243 091 B1**
(45) Date of publication and mention of the grant of the patent: **22.07.2026**
(21) Application number: 22899633.6
(22) Date of filing: 24.01.2022
(51) Int. Cl.: H10F 19/33, H10F 19/35, H10F 77/169, H10F 77/20, H10K 85/50, H10K 39/10

(54) **SOLAR CELL AND METHOD FOR PREPARING SAME, PHOTOVOLTAIC MODULE AND POWER CONSUMING DEVICE**
SOLARZELLE UND VERFAHREN ZUR HERSTELLUNG DAVON, FOTOVOLTAISCHES MODUL UND STROMVERBRAUCHENDE VORRICHTUNG
CELLULE SOLAIRE ET SON PROCÉDÉ DE PRÉPARATION, MODULE PHOTOVOLTAÏQUE ET DISPOSITIF ÉLECTRIQUE

(43) Date of publication of application: 13.09.2023
(73) Proprietor: Contemporary Amperex Technology (Hong Kong) Limited, Central, Central And Western District (HK)
(72) Inventor: WANG, Yanfen, Ningde City, Fujian 352100 (CN); LIU, Zhaohui, Ningde City, Fujian 352100 (CN); WANG, Yandong, Ningde City, Fujian 352100 (CN); SU, Shuojian, Ningde City, Fujian 352100 (CN); WU, Tianlong, Ningde City, Fujian 352100 (CN); LIN, Weile, Ningde City, Fujian 352100 (CN); CHEN, Guodong, Ningde City, Fujian 352100 (CN); GUO, Yongsheng, Ningde City, Fujian 352100 (CN)
(74) Representative: Rowlands, Stuart Michael
(86) International application number: PCT/CN2022/073526
(87) International publication number: WO 2023/137756

(56) References cited:
- CN-A- 101 419 989
- CN-A- 103 367 483
- CN-A- 103 367 483
- CN-A- 104 600 148
- CN-A- 112 186 056
- CN-A- 112 186 056
- US-A1- 2001 015 221

## Description

### Technical Field

The present application relates to the field of cell production technologies, and in particular, to a solar cell and a method for preparing the same, a photovoltaic module, and a power consuming device.

### Background Art

Solar cells are photovoltaic conversion devices that directly convert light energy into electrical energy, and they have an excellent photovoltaic property and are simple to prepare, bringing new space and hope to photovoltaic power generation.

In a production process of solar cells, how to further improve the photovoltaic conversion efficiency of the solar cells is an urgent problem to be solved.

CN112186056A relates to a preparation method for a solar cell module comprising comprises the steps: cutting a cell piece into an intermediate cell unit and at least one peripheral cell unit, andenabling the peripheral cell unit to be disposed at the periphery of the intermediate cell unit; and an electrical connection step of connecting the intermediate cell unit and the at least one peripheral cell unit in series.

CN103367483A relates to a solar cell comprising two photoelectric conversion assemblies which are connected in parallel, wherein the photoelectric conversion assembly comprises a plurality of fan-shaped solar cell units which are connected in series; the shape of the solar cell is round; and positive electrodes of the two photoelectric conversion assemblies are internally connected, and negative electrodes of the two photoelectric conversion assemblies are internally connected.

CN104600148A relates to an amorphous silicon thin film solar cell, belongs to the technical field of solar energy, and aims at solving the problems of falling of PIN amorphous silicon film layer and a back electrode film layer and large electricity leakage. The amorphous silicon thin film solar cell and the manufacturing method are characterized in that a PIN photoelectric conversion layer completely covers a front electrode graphic ITO transparent conductive film layer; an export copper paste electrode covers the back paint surface and the carbon paste electrode surface at an opening in a back paint protecting layer; the attaching force of the copper paste electrode is more than 0.6kg.

### Summary of the Invention

The present application has been made in view of the above problems, and an objective of the present application is to provide a solar cell and a method for preparing the same, a photovoltaic module, and a power consuming device, so as to improve the photovoltaic conversion efficiency of the solar cell.

To achieve the above objective, an embodiment in a first aspect of the present application provides a solar cell as set out in claim 1, including a substrate and a plurality of sub-cells connected in series on the substrate, the plurality of sub-cells being sequentially disposed along a first direction, where the first direction is parallel to an outline trajectory of the substrate.

Therefore, in the embodiment of the present application, the plurality of sub-cells are sequentially arranged along the outline trajectory of the substrate to form the solar cell, and the solar cell has a wider application range. In addition, the solar cell of such a structure is relatively small in an area of the dead region and has a relatively small series resistance, so that a photocurrent output by each sub-cell can be increased, thereby improving photovoltaic conversion efficiency of the solar cell.

In any implementation, each of the plurality of sub-cells includes a power generation region, the power generation regions have equal cross-sectional areas in a direction perpendicular to a thickness direction of the power generation regions, and the thickness direction is perpendicular to the first direction.

Therefore, the sub-cells are equal in areas of regions where photons may be utilized, substantially the same in light absorption capabilities and light conversion efficiency, and substantially the same in output photocurrents, so that a risk of current limiting caused by some of the sub-cells can be reduced, and therefore the photovoltaic conversion efficiency of the solar cell can be improved. In addition, a risk of hot spots generated by the sub-cells can be reduced, so that device stability of the solar cell can be improved.

In any implementation, the sub-cell includes a dead region, and an extension direction of the dead region, the first direction, and a thickness direction of the solar cell are perpendicular to each other. The dead region extends from the outline of the substrate to the geometric center of the substrate, and the dead region has a relatively small area, so that a series resistance of the sub-cell may be significantly reduced, and a photocurrent output by the sub-cell may be increased, thereby improving the photovoltaic conversion efficiency of the solar cell.

At least part of the substrate has unequal thicknesses along the first direction; and/or at least part of a cross section of the substrate in a direction perpendicular to the thickness direction of the solar cell is in an irregular shape, and the thickness direction is perpendicular to the first direction. The plurality of sub-cells may be flexibly disposed according to a structure of the substrate, so as to expand an application range of the solar cell.

In any implementation, the cross section of the substrate in the direction perpendicular to the thickness direction of the solar cell is circular or elliptical, and the plurality of sub-cells are sequentially arranged along a circumferential direction of the substrate. The plurality of sub-cells are sequentially arranged along the circumferential direction, so that the solar cell may be formed by fully utilizing the circular or elliptical substrate, and the solar cell may have a wider application range.

At least part of the substrate is of a curved surface structure. According to the embodiment of the present application, the plurality of sub-cells are disposed on the curved surface structure, and are sequentially disposed along the outline trajectory of the substrate, so that the application range of the solar cell is expanded.

In any implementation, the solar cell includes a hollowed-out portion, and the plurality of sub-cells are sequentially arranged around the periphery of the hollowed-out portion. The sub-cells are separated by the hollowed-out portion, to reduce a risk of short circuit of the sub-cells caused by direct contact of the sub-cells.

In any implementation, each of the plurality of sub-cells includes a first electrode layer, a photovoltaic conversion module, and a second electrode layer that are sequentially stacked along the thickness direction of the solar cell, the first electrode layer is disposed between the substrate and the photovoltaic conversion module, and the first electrode layer of one of the plurality of sub-cells is electrically connected to the second electrode layer of another sub-cell, such that the plurality of sub-cells are connected in series; and the solar cell includes at least an electrode portion located in the hollowed-out portion, and the electrode portion is connected to the second electrode layer of one of the sub-cells.

Therefore, in the embodiment of the present application, the electrode portion is connected to one of the sub-cells, so that the space of the hollowed-out portion is fully utilized, and the solar cell can be supported and strengthened. In addition, an electrode lead may be connected to the electrode portion, so as to reduce an impact on other sub-cells caused in a process of disposing the electrode lead.

In any implementation, the solar cell includes a first electrode wire, and the first electrode wire is connected to the electrode portion. Disposing the first electrode wire on the electrode portion can reduce a risk of damage to the second electrode layer in a processing process. Exemplarily, the first electrode wire is welded on the electrode portion using a welding method or the like.

In any implementation, the photovoltaic conversion module includes a first charge transport layer, a photovoltaic conversion layer, and a second charge transport layer that are sequentially stacked along the thickness direction of the sub-cell, and the first charge transport layer is located between the first electrode layer and the photovoltaic conversion layer.

The material of the first charge transport layer includes at least one of poly[bis(4-phenyl)(2,4,6-trimethylphenyl)amine (PTAA), poly(3,4-ethylenedioxythiophene) (PEDOT), nickel oxide (NiOx), CuI, and Cu₂O. The first charge transport layer is disposed between the first electrode layer and the photovoltaic conversion layer, so that a good ohmic contact can be formed, and electron holes can be effectively transported, thereby reducing recombination of carriers at the interface, and improving the photovoltaic conversion efficiency.

The material of the photovoltaic conversion layer conforms to the ABX₃ crystal structure, where A includes at least one of methylammonium (MA), formamide (FA), and cesium (Cs), B includes at least one of plumbum (Pb), stannum (Sn), and cuprum (Cu), and X includes at least one of bromine (Br), chlorine (Cl), and iodine (I). The photovoltaic conversion layer may absorb photons and convert light into electrons and electron holes, and respectively transport electrons and electron holes to the first charge transport layer and the second charge transport layer under the action of a built-in electric field.

The material of the second charge transport layer includes at least one of C60, stannic oxide (SnO₂), a fullerene derivative (PCBM), and titanium oxide (TiO₂). The second charge transport layer is disposed between the photovoltaic conversion layer and the second electrode layer, so that the energy level potential barrier between the photovoltaic conversion layer and the second electrode layer can be reduced, which is conducive to transporting electrons and improving electron transport efficiency. In addition, the second charge transport layer is conducive to transporting electrons, blocking electron holes, and reducing a risk of recombination of carriers at the interface.

In any implementation, the material of each of the first electrode layer and the second electrode layer is independently selected from aurum (Au), argentum (Ag), cuprum (Cu), aluminum (Al), a transparent conductive oxide (TCO), or carbon. The metal material has a large number of free electrons, and therefore has good metallic conductivity. The transparent conductive material has electrical conductivity and light transmittance.

A second aspect of the present application provides a photovoltaic module, including a plurality of solar cells according to the embodiment in the first aspect of the present application.

A third aspect of the present application provides a power consuming device, including a plurality of photovoltaic modules according to the embodiment in the second aspect of the present application.

A fourth aspect of the present application provides a method, as set out in claim 11, for preparing a solar cell, including: providing a substrate; forming a bottom electrode on one side of the substrate, and removing a central part of the bottom electrode, the bottom electrode including a plurality of first electrode layers disposed at intervals along a first direction, such that the solar cell is divided into a plurality of sub-cells, the first direction being parallel to an outline trajectory of the solar cell; forming a photovoltaic conversion module on a surface of the first electrode layer of each of the plurality of sub-cells that faces away from the substrate; and forming a top electrode on a surface of the photovoltaic conversion module that faces away from the substrate, the top electrode including a plurality of second electrode layers disposed at intervals, and the first electrode layer of one of the plurality of sub-cells being configured to be electrically connected to the second electrode layer of another sub-cell, such that the plurality of sub-cells are electrically connected.

In any implementation, an electrode portion is formed in a hollowed-out portion, and the electrode portion is connected to the second electrode layer of one of the sub-cells, where the hollowed-out portion penetrates the photovoltaic conversion module and the bottom electrode.

### Brief Description of the Drawings

Features, advantages, and technical effects of exemplary embodiments of the present application will be described below with reference to accompanying drawings.
FIG. 1 is a schematic structural diagram of a vehicle provided in some embodiments of the present application;
FIG. 2 is a schematic block diagram of a photovoltaic module provided in some embodiments of the present application;
FIG. 3 is a schematic structural diagram of a solar cell provided in some embodiments of the present application;
FIG. 4 is a schematic structural diagram of a solar cell provided in some other embodiments of the present application;
FIG. 5 is a schematic diagram of a partial structure of a solar cell provided in some embodiments of the present application;
FIG. 6 is a schematic diagram of a process of preparing a solar cell provided in some embodiments of the present application;
FIG. 7 shows a process of preparing a solar cell provided in some embodiments of the present application;
FIG. 8 is a top view of FIG. 7;
FIG. 9 shows another process of preparing a solar cell provided in some embodiments of the present application;
FIG. 10 is a top view of FIG. 9;
FIG. 11 shows still another process of preparing a solar cell provided in some embodiments of the present application;
FIG. 12 is a top view of FIG. 11;
FIG. 13 is a schematic structural diagram of a solar cell provided in some still other embodiments of the present application; and
FIG. 14 is a schematic diagram of a process of preparing a solar cell provided in some other embodiments of the present application.

The accompanying drawings may not be drawn to the actual scale.

Reference signs in the drawings are as follows:
X: first direction; Y: thickness direction; Z: extension direction;
P1: first hollowed-out portion; P2: second hollowed-out portion; P3: third hollowed-out portion;
1: vehicle; 2: photovoltaic module; 3: controller; 4: motor;
5: solar cell;
50: substrate;
51: first electrode layer;
52: photovoltaic conversion module; 521: first charge transport layer; 522: photovoltaic conversion layer; 523: second charge transport layer;
53: second electrode layer;
54: hollowed-out portion;
55: electrode portion;
56: first electrode wire;
57: central part;
6: sub-cell; 6a: power generation region; 6b: dead region; 61: first cell; 62: second cell; 63: third cell; 64: fourth cell.

### Detailed Description of Embodiments

The implementations of the present application will be further described in detail below in conjunction with the accompanying drawings and embodiments. The following detailed description of the embodiments and the accompanying drawings are used to illustrate the principle of the present application by way of example but should not be used to limit the scope of the present application. That is, the present application is not limited to the described embodiments.

In the description of the present application, it should be noted that "a plurality of" means two or more, unless otherwise specified. The orientation or position relationship indicated by the terms "upper", "lower", "left", "right", "inner", "outer", etc. is only for the convenience of describing the present application and simplifying the description, rather than indicating or implying that the device or element referred to must have a particular orientation or be constructed and operated in a particular orientation, and therefore should not be construed as a limitation on the present application. In addition, the terms "first", "second", "third", etc. are used for descriptive purposes only, and should not be construed as indicating or implying the relative importance. The term "perpendicular" does not mean being perpendicular in the strict sense, but within an allowable range of errors. The term "parallel" does not mean being parallel in the strict sense, but within an allowable range of errors.

The orientation terms in the following description all indicate directions shown in the drawings, but do not limit the specific structure in the present application. In the description of the present application, it should also be noted that the terms "mounting", "connecting", and "connection" should be interpreted in the broad sense unless explicitly defined and limited otherwise. For example, the terms may mean a fixed connection, a detachable connection, or an integral connection, or may mean a direct connection, or an indirect connection by means of an intermediate medium. For those of ordinary skill in the art, the specific meanings of the terms mentioned above in the present application can be construed according to specific circumstances.

In the embodiments of the present application, a solar cell is a photovoltaic conversion device that directly converts light energy into electrical energy on a theoretical basis of the photovoltaic effect. A solar cell includes a photovoltaic conversion module for photovoltaic conversion, a transport layer, and an electrode layer. Due to the use of different materials for the photovoltaic conversion module, the transport layer, and the electrode layer, and a difference in quasi-fermi levels of the different materials, a built-in electric field is formed inside the photovoltaic conversion device. As a light absorption material for the solar cell, the photovoltaic conversion module absorbs photons to generate electron-electron hole pairs, which can be split into free carriers, then the generated free carriers drift in the opposite directions under the action of the built-in electric field, the electrons move to the negative electrode, the electron holes move to the positive electrode, and the electrons and electron holes are respectively transported by different transport layers and then collected by the electrode layer, thereby forming a potential difference between the positive electrode and negative electrode, generating a current, and completing the entire photovoltaic conversion process.

Performance of a solar cell may be reflected by a short-circuit current density, an open-circuit voltage, a fill factor, photovoltaic conversion efficiency, etc.

The short-circuit current density is a current density obtained when the solar cell is in a short-circuit state, that is, a voltage across both terminals of the solar cell is zero. A short-circuit current is generated by generation and collection of photo-generated carriers, which is related to optical characteristics of the solar cell, frequency of an incident light source, an interface loss, etc.

The open-circuit voltage refers to a potential difference between both terminals of the solar cell that is obtained when a current through an external circuit of the solar cell is zero, that is, the circuit is in an open-circuit state.

The fill factor refers to a ratio of a maximum power of the solar cell to (a product of the short-circuit current density and the open-circuit voltage). When a series resistance of the solar cell is smaller and a parallel resistance is larger, the fill factor is higher.

The photovoltaic conversion efficiency refers to a ratio of a maximum power output of the solar cell to an incident light power. The photovoltaic conversion efficiency of the solar cell may be effectively improved by adjusting the short-circuit current density, the open-circuit voltage, and the fill factor. For example, in the field of solar cells, the photovoltaic conversion efficiency is used to evaluate the performance of solar cells. The larger the fill factor, the higher the photovoltaic conversion efficiency and the better the performance of the solar cells.

For a large-area solar cell, a plurality of sub-cells are obtained through scribing, to obtain a required voltage and current output. For example, first scribing, second scribing, and third scribing are performed by using a laser or mechanical marking method or the like, to implement division and electrical connection (for example, series connection) of the solar cell. A scribing process is as follows: forming a first electrode layer on a substrate; performing scribing to form a first hollowed-out portion, to complete division of sub-cells; forming a photovoltaic conversion module on one side of the first electrode layer that faces away from the substrate, and performing scribing to form a second hollowed-out portion, to complete scribing of channels for series connection of the sub-cells; and forming a second electrode layer on the side of the photovoltaic conversion module that faces away from the substrate, and performing scribing to form a third hollowed-out portion, to complete division of the second electrode layer.

The sub-cell includes a power generation region and a dead region. The dead region is disposed between the power generation regions of two adjacent sub-cells, that is, a region between the first hollowed-out portion and the third hollowed-out portion. The power generation region is a region where light can be effectively used for photovoltaic conversion, for example, a region of each sub-cell where photovoltaic conversion can be performed. In the dead region, light cannot be used, resulting in light waste. There is a contact resistance between the first electrode layer and the second electrode layer that are located in the dead region, and the photovoltaic conversion module located in the dead region has a specific resistance. The above resistances constitute a series resistance, and the larger the series resistance, the smaller a photocurrent; and the smaller the series resistance, the smaller a value of the photocurrent. Moreover, from another point of view, because the fill factor is positively correlated with the series resistance, that is, the larger the series resistance, the lower a value of the fill factor, thereby reducing the photovoltaic conversion efficiency; and the smaller the series resistance, the higher the value of the fill factor, thereby improving the photovoltaic conversion efficiency.

The inventor found that a substrate of an existing solar cell has a rectangular structure, and has a relatively small application range, and on the substrate of the rectangular structure, it is considered to reduce sizes of a first hollowed-out portion, a second hollowed-out portion, and a third hollowed-out portion in the dead region, so as to improve the photovoltaic conversion efficiency, thereby reducing an area of the dead region and the loss of light in the dead region. However, limited by the process, the area of the dead region cannot be reduced infinitely. As a result, the area of the dead region cannot be significantly reduced, and consequently the photovoltaic conversion efficiency cannot be significantly improved.

In view of this, the present application provides a technical solution, and in the technical solution, a solar cell includes a substrate and a plurality of sub-cells connected in series on the substrate, the plurality of sub-cells being sequentially disposed along a first direction, where the first direction is parallel to an outline trajectory of the substrate. The solar cell of such a structure can be significantly improved in the photovoltaic conversion efficiency thereof.

The technical solution described in the embodiments of the present application is applicable to a photovoltaic module including a solar cell and a power consuming device using the photovoltaic module.

The power consuming device may be a vehicle, a mobile phone, a portable device, a notebook computer, a ship, a spacecraft, an electric toy, an electric tool, etc. The vehicle may be a fuel vehicle, a natural gas vehicle, or a new energy vehicle. The spacecraft includes an airplane, a rocket, an aerospace plane, a spaceship, etc. The electric toy includes a stationary or mobile electric toy, such as a game machine, an electric toy car, an electric toy ship, and an electric toy airplane. The electric tool includes a metal cutting electric tool, a grinding electric tool, an assembling electric tool, and a railway electric tool, such as an electric drill, an electric grinder, an electric wrench, an electric screwdriver, an electric hammer, an electric impact drill, a concrete vibrator, and an electric planer. The foregoing power consuming devices are not specifically limited in the embodiments of the present application.

For ease of description, an example in which a power consuming device refers to a vehicle is used for description in the following embodiments.

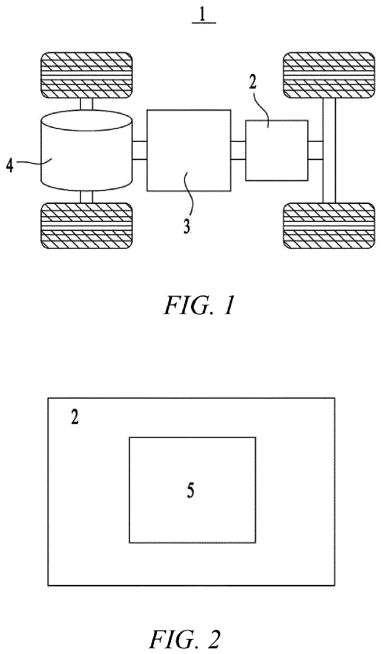

As shown in FIG. 1, a photovoltaic module 2 is provided inside a vehicle 1, and the photovoltaic module 2 may be disposed at the top, the head, or the tail of the vehicle 1. The photovoltaic module 2 may be configured to supply power to the vehicle 1. For example, the photovoltaic module 2 may be used as an operating power supply of the vehicle 1.

The vehicle 1 may further include a controller 3 and a motor 4. The controller 3 is configured to control the photovoltaic module 2 to supply power to the motor 4, for example, to satisfy working power requirements during starting, navigation, and traveling of the vehicle 1.

As shown in FIG. 2, the photovoltaic module 2 includes a solar cell 5. There may be one or more solar cells 5. If there are a plurality of solar cells 5, the plurality of solar cells 5 may be connected in series or in parallel or in series and parallel. The series and parallel connection means that the plurality of solar cells 5 are connected in series and parallel, which can provide a higher voltage and capacity.

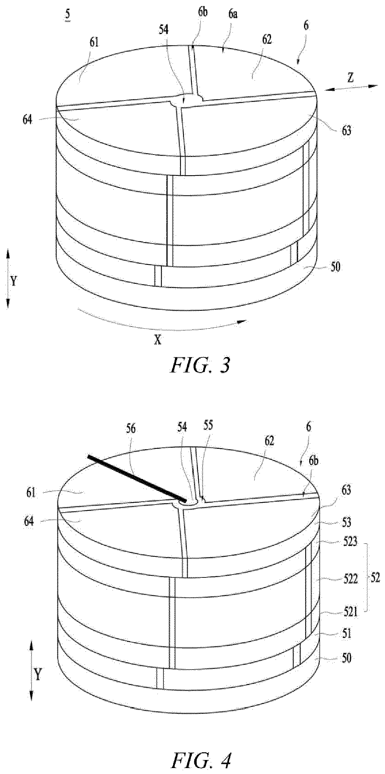

As shown in FIG. 3, an embodiment of the present application provides a solar cell 5. The solar cell 5 includes a substrate 50 and a plurality of sub-cells 6 connected in series on the substrate 50, the plurality of sub-cells 6 being sequentially disposed along a first direction X, where the first direction X is parallel to an outline trajectory of the substrate 50.

The substrate 50 is used as a bearing base and has insulating properties, and the substrate 50 may be a flexible substrate or a rigid substrate. The rigid substrate may include a glass substrate; and the flexible substrate may be made of polyethylene glycol terephthalate (PEI) or polyimide (PI).

The substrate 50 has a variety of structures. Specifically, the substrate 50 may be of a regular geometric structure such as a circular structure, an elliptical structure, a polygonal structure, or the like, where the polygonal structure may include a rectangular structure, a pentagonal structure, a hexagonal structure, etc.; or may be of an irregular geometric structure, for example, part of the substrate 50 is of an arc-shaped structure, and the other part is of an asymmetrical structure of a polygonal structure. In addition, the substrate 50 may have equal or unequal thicknesses. For example, the substrate 50 is of a circular structure. In unclaimed arrangements, the substrate 50 having equal thicknesses is reflected in that a surface of the substrate 50 is a plane; and, in claimed arrangements, the substrate 50 having unequal thicknesses is reflected in that a surface of the substrate 50 is a curved surface. Certainly, the above is merely an exemplary description of the substrate 50, and the structure of the substrate 50 is not limited to the above examples.

The outline trajectory of the substrate 50 refers to a shape of the outer contour of the substrate 50. Exemplarily, the substrate 50 is of a circular structure, and the outline trajectory of the substrate 50 refers to the periphery of the circular structure; alternatively, the substrate 50 has a rectangular structure, and the outline trajectory of the substrate 50 refers to the outer contour of the rectangular structure, that is, the contour formed by the four edges of the rectangular structure.

The sub-cell 6 is a device with a photovoltaic conversion function, and can lead a current out. The plurality of sub-cells 6 being connected in series may be that the plurality of sub-cells 6 are connected in series through an intermediate member. Certainly, positive and negative electrodes of the plurality of sub-cells 6 may be directly connected in turn to implement series connection of the sub-cells. The direct connection of the positive and negative electrodes in turn may improve reliability of the series connection under the condition that a connection distance is relatively short and ensure performance stability of the solar cell 5.

The plurality of sub-cells 6 are sequentially arranged along the first direction X, that is, arranged in turn along the outline trajectory of the substrate 50. The plurality of sub-cells 6 substantially cover all surfaces of the substrate 50, and a utilization rate of the substrate 50 is high. Two adjacent sub-cells 6 may be mechanically connected, to implement electrical connection between the two adjacent sub-cells 6. Exemplarily, the plurality of sub-cells 6 include a first cell 61, a second cell 62, a third cell 63, and a fourth cell 64, the first cell 61, the second cell 62, the third cell 63, and the fourth cell 64 are sequentially arranged along a first direction X, the first cell 61 and the second cell 62 are connected in series, the second cell 62 and the third cell 63 are connected in series, the third cell 63 and the fourth cell 64 are connected in series, and electrons and electron holes are respectively led out from the first cell 61 and the fourth cell 64 to form a current. Certainly, the plurality of sub-cells 6 may alternatively include two sub-cells 6, three sub-cells 6, five sub-cells 6, or the like. The number of sub-cells 6 may be flexibly adjusted according to a structure of the substrate 50.

The solar cell 5 is divided into a plurality of sub-cells 6 through scribing. Each sub-cell 6 formed after the division includes a power generation region 6a and a dead region 6b. The solar cell 5 with such a structure is relatively small in an area of the dead region 6b, which can reduce a series resistance.

Therefore, in the embodiment of the present application, the plurality of sub-cells 6 are sequentially arranged along the outline trajectory of the substrate 50 to form the solar cell 5, and the solar cell 5 has a wider application range. In addition, the solar cell 5 of such a structure is relatively small in an area of the dead region 6b and has a relatively small series resistance, so that a photocurrent output by each sub-cell 6 can be increased, thereby improving photovoltaic conversion efficiency of the solar cell 5.

In some embodiments, each of the plurality of sub-cells 6 includes a power generation region 6a, the power generation regions 6a have equal cross-sectional areas in a direction perpendicular to a thickness direction Y of the power generation regions, and the thickness direction Y is perpendicular to the first direction X. The power generation region 6a is a region of the sub-cell 6 where photons can be utilized. The power generation regions 6a have equal cross-sectional areas in a direction perpendicular to the thickness direction Y of the power generation regions. In other words, the sub-cells 6 are equal in areas of regions where photons may be utilized, substantially the same in light absorption capabilities and light conversion efficiency, and substantially the same in output photocurrents, so that a risk of current limiting caused by some of the sub-cells 6 can be reduced, and therefore the photovoltaic conversion efficiency of the solar cell 5 can be improved; and a risk of hot spots generated by the sub-cells 6 can be reduced, so that device stability of the solar cell 5 can be improved.

As shown in FIG. 3, in some embodiments, the sub-cell 6 includes a dead region 6b, and an extension direction Z of the dead region 6b, the first direction X, and a thickness direction Y of the solar cell 5 are perpendicular to each other. The dead region 6b is formed in the process of dividing the solar cell 5 through scribing. The dead region 6b extends from the outline of the substrate 50 to the geometric center of the substrate 50, and the dead region 6b has a relatively small area, so that a series resistance of the sub-cell 6 may be significantly reduced, and a photocurrent output by the sub-cell 6 may be increased, thereby improving the photovoltaic conversion efficiency of the solar cell 5. Exemplarily, the substrate 50 is of a circular structure, and the extension direction Z of the dead region 6b is substantially parallel to the radial direction of the circular structure, and since there are a plurality of dead regions 6b, the extension directions Z of the plurality of dead regions 6b are substantially parallel to the radial direction, but the extension directions Z of the plurality of dead regions 6b are parallel to different radial directions. The first direction X is parallel to the circumferential direction of the circular structure, the thickness direction Y of the solar cell 5 is parallel to the axial direction of the circular structure, and the radial direction, circumferential direction, and the axial direction are perpendicular to each other.

Optionally, the dead regions 6b have equal cross-sectional areas in a direction perpendicular to the thickness direction Y of the dead regions, the dead region 6b is a region of the sub-cell 6 where photons cannot be utilized substantially, and the dead regions 6b are regions where the series resistance of the sub-cell 6 is mainly constituted. Setting the cross-sectional areas of the dead regions 6b in the direction perpendicular to the thickness direction Y of the dead regions to be equal can ensure, to a certain extent, that the series resistances of the sub-cells 6 are substantially the same, so that a risk of current limiting caused by some of the sub-cells 6 can be reduced.

In some embodiments, at least part of the substrate 50 has unequal thicknesses along the first direction X. At least part of the substrate 50 having unequal thicknesses means that the substrate 50 is partially unequal in thicknesses or unequal in thicknesses as a whole. In this case, at least one surface of the substrate 50 is a curved surface. The plurality of sub-cells 6 may be flexibly disposed according to a structure of the substrate 50, so as to expand an application range of the solar cell 5.

In some embodiments, at least part of a cross section of the substrate 50 in a direction perpendicular to the thickness direction Y of the solar cell 5 is in an irregular shape, and the thickness direction Y is perpendicular to the first direction X. At least part of the cross section of the substrate 50 in the direction perpendicular to the thickness direction being in an irregular shape means that a part of the cross section of the substrate 50 in the direction perpendicular to the thickness direction Y is in an irregular shape and the other part is in a regular shape; or that the cross section of the substrate 50 in the direction perpendicular to the thickness direction Y is in an irregular shape as a whole. The plurality of sub-cells 6 may be flexibly disposed according to a structure of the substrate 50.

At least part of the substrate 50 having unequal thicknesses and the cross section of the substrate 50 in the direction perpendicular to the thickness direction Y being in an irregular shape may both exist, or either of the two exists. Exemplarily, the substrate 50 has unequal thicknesses, and the cross section of the substrate 50 in the direction perpendicular to the thickness direction Y is in an irregular shape. Alternatively, the substrate 50 has unequal thicknesses, and the cross section of the substrate 50 in the direction perpendicular to the thickness direction Y is in a regular shape. Alternatively, the substrate 50 has equal thicknesses, and the cross section of the substrate 50 in the direction perpendicular to the thickness direction Y is in an irregular shape.

Exemplarily, the cross section of the substrate 50 in the direction perpendicular to the thickness direction Y is circular or elliptical, and the plurality of sub-cells 6 are sequentially arranged along a circumferential direction of the substrate 50. The plurality of sub-cells 6 are sequentially arranged along the circumferential direction, so that the solar cell 5 may be formed by fully utilizing the circular or elliptical substrate 50, and the solar cell 5 may have a wider application range.

In some embodiments, at least part of the substrate 50 is of a curved surface structure. According to the embodiment of the present application, the plurality of sub-cells 6 are disposed on the curved surface structure, and are sequentially disposed along the outline trajectory of the substrate 50, so that the application range of the solar cell 5 is expanded. The curved surface structure may be a structure having equal or unequal thicknesses.

Certainly, the substrate 50 may be of another structure, different from the above structure, that have equal thicknesses and a cross section in a regular shape in a direction perpendicular to the thickness direction, for example, the substrate 50 may be of a circular structure having uniform thicknesses.

As shown in FIG. 3, in some embodiments, the solar cell 5 further includes a hollowed-out portion 54, and the plurality of sub-cells 6 are sequentially arranged around the periphery of the hollowed-out portion 54. The sub-cells 6 are separated by the hollowed-out portion 54, to reduce a risk of short circuit of the sub-cells 6 caused by direct contact of the sub-cells. The hollowed-out portion 54 may be of a cavity structure, or filled with an insulating material.

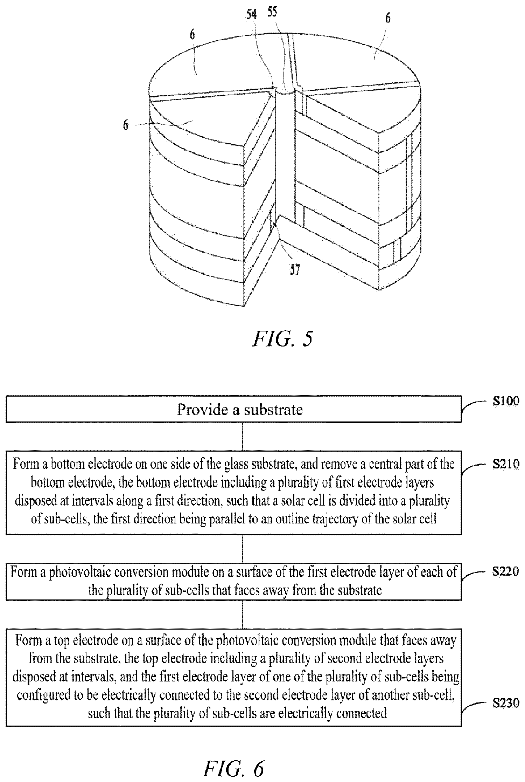

As shown in FIG. 4 and FIG. 5, optionally, an electrode portion 55 may be provided in the hollowed-out portion 54, the electrode portion 55 is connected to one of the sub-cells 6, so that the space of the hollowed-out portion 54 is fully utilized, and the solar cell 5 can be supported and strengthened. In addition, an electrode lead may be connected to the electrode portion 55, so as to reduce an impact on other sub-cells 6 caused in a process of disposing the electrode lead.

Next, a structure of the sub-cell 6 will be described.

The sub-cell 6 may include a first electrode layer 51, a photovoltaic conversion module 52, and a second electrode layer 53 that are sequentially stacked along the thickness direction X of the solar cell 5. The first electrode layer 51 is disposed between the substrate 50 and the photovoltaic conversion module 52, and the first electrode layer 51 of one of the plurality of sub-cells 6 is electrically connected to the second electrode layer 53 of another sub-cell 6, such that the plurality of sub-cells 6 are connected in series.

The solar cell 5 includes at least the electrode portion 55 located in the hollowed-out portion 54, and the electrode portion 55 is connected to the second electrode layer 53 of one of the sub-cells 6. The space of the hollowed-out portion 54 may be fully utilized by the electrode portion 55, so that an area of the dead region 6b is reduced, and the solar cell 5 can be supported and strengthened.

Still referring to FIG. 4 and FIG. 5, optionally, the solar cell 5 includes a first electrode wire 56, and the first electrode wire 56 is connected to the electrode portion 55. The first electrode wire 56 leads charges in the electrode portion 55 out. In addition, disposing the first electrode wire 56 on the electrode portion 55 can reduce a risk of damage to the second electrode layer 53 in a processing process. Exemplarily, the first electrode wire 56 is welded on the electrode portion 55 using a welding method or the like.

Certainly, the first electrode wire 56 may alternatively be disposed on the second electrode layer 53, and the second electrode layer 53 has a relatively large area and a relatively high fault tolerance rate.

The first electrode layer 51 and the second electrode layer 53 are separately configured to be electrically connected to the photovoltaic conversion modules 52, the first electrode layer 51 is configured to collect electron holes, and the second electrode layer 53 is configured to collect electrons. The first electrode layer 51 and the second electrode layer 53 may be made of the same material or different materials. Exemplarily, both the first electrode layer 51 and the second electrode layer 53 may be made of a metal material, or the first electrode layer 51 may be made of a transparent conductive material, and the second electrode layer 53 may be made of a metal material or the like. The metal material has a large number of free electrons, and therefore has good metallic conductivity. The transparent conductive material has electrical conductivity and light transmittance. Specifically, the material of each of the first electrode layer 51 and the second electrode layer 53 is independently selected from aurum (Au), argentum (Ag), cuprum (Cu), aluminum (Al), a transparent conductive oxide (TCO), or carbon. TCO includes fluorine-doped tin oxide (FTO, SnO2:F), indium tin oxide (ITO, In₂O₃:Sn), aluminum-doped zinc oxide (AZO, ZnO:Al), or antimony-doped tin oxide (ATO, Sn₂O:Sb). In the above abbreviations, SnO₂:F is used as an example, and represents tin oxide (SnO2) doped with fluorine (F).

The photovoltaic conversion module 52 serves as a core function layer of the sub-cell 6, and a main function of the photovoltaic conversion module is to absorb external light to form electron-electron hole pairs inside the photovoltaic conversion module, and the electrons and electron holes are split, extracted, and output for external output. Exemplarily, the photovoltaic conversion module 52 may be a perovskite photovoltaic conversion module 52, or another photovoltaic conversion module such as a cadmium zinc telluride photovoltaic conversion module or a copper indium gallium selenide photovoltaic conversion module.

The photovoltaic conversion module 52 may include a plurality of transport layers for transporting electrons and electron holes, respectively. Certainly, the photovoltaic conversion module 52 may further include a function layer for improving transport efficiency of electrons and electron holes and reducing a risk of recombination of electrons and electron holes.

The photovoltaic conversion module 52 includes a first charge transport layer 521, a photovoltaic conversion layer 522, and a second charge transport layer 523 that are sequentially stacked along the thickness direction Y of the sub-cell 6, and the first charge transport layer 521 is located between the first electrode layer 51 and the photovoltaic conversion layer 522. The first charge transport layer 521 is an electron hole transport layer, and the second charge transport layer 523 is an electron transport layer. The solar cell 5 includes the substrate 50, the first electrode layer 51, the first charge transport layer 521, the photovoltaic conversion layer 522, the second charge transport layer 523, and the second electrode layer 53 that are sequentially arranged along the thickness direction of the solar cell.

The material of the first charge transport layer 521 includes at least one of poly[bis(4-phenyl)(2,4,6-trimethylphenyl)amine (PTAA), poly(3,4-ethylenedioxythiophene) (PEDOT), nickel oxide (NiOx), CuI, and Cu2O. The first charge transport layer 521 is disposed between the first electrode layer 51 and the photovoltaic conversion layer 522, so that a good ohmic contact can be formed, electron holes can be effectively transported, recombination of carriers at the interface can be reduced, and the photovoltaic conversion efficiency can be improved.

The material of the photovoltaic conversion layer 522 conforms to the ABX3 crystal structure, the ABX3 crystal structure is a crystal structure of an organic-inorganic hybrid perovskite material, which is of a cubic or octahedral structure. A includes at least one of methylammonium (MA), formamide (FA), and cesium (Cs), B includes at least one of plumbum (Pb), stannum (Sn), and cuprum (Cu), and X includes at least one of bromine (Br), chlorine (Cl), and iodine (I). The photovoltaic conversion layer 522 may absorb photons and convert light into electrons and electron holes, and respectively transport electrons and electron holes to the first charge transport layer 521 and the second charge transport layer 523 under the action of a built-in electric field.

The material of the second charge transport layer 523 includes at least one of C60, stannic oxide (SnO₂), a fullerene derivative (PCBM), and titanium oxide (TiO₂). The second charge transport layer 523 is disposed between the photovoltaic conversion layer 522 and the second electrode layer 53, so that the energy level potential barrier between the photovoltaic conversion layer 522 and the second electrode layer 53 can be reduced, which is conducive to transporting electrons and improving electron transport efficiency. In addition, the second charge transport layer 523 is conducive to transporting electrons, blocking electron holes, and reducing a risk of recombination of carriers at the interface.

The working principle of the solar cell 5 is described by taking an example in which the solar cell 5 includes four sub-cells 6. The second electrode layer 53 of the first cell 61 is connected to the first electrode layer 51 of the second cell 62, the second electrode layer 53 of the second cell 62 is connected to the first electrode layer 51 of the third cell 63, and the second electrode layer 53 of the third cell 63 is connected to the first electrode layer 51 of the fourth cell 64. The second electrode layer 53 of the first cell 61 is connected to the electrode portion 55, and the electrode portion 55 is connected to the first electrode wire 56, so as to transport carriers. The first electrode layer 51 of the fourth cell 64 is connected to a second electrode wire, so as to transport carriers. The first cell 61 and the fourth cell 64 are respectively the head cell and the tail cell in the series connection.

As shown in FIG. 6, an embodiment of the present application further provides a method for preparing a solar cell, including:
S100: providing a substrate; and
S200: performing division of sub-cells.

Step S200 of performing division of sub-cells specifically includes: sequentially arranging a plurality of sub-cells connected in series along a first direction, where the first direction is parallel to an outline trajectory of the substrate. According to the solar cell prepared in the embodiment of the present application, photovoltaic conversion efficiency of the solar cell can be effectively improved.

Step S200 specifically includes the following steps.

In S210, a bottom electrode is formed on one side of the glass substrate, and a central part of the bottom electrode is removed, the bottom electrode including a plurality of first electrode layers disposed at intervals along a first direction, such that the solar cell is divided into a plurality of sub-cells, the first direction being parallel to an outline trajectory of the solar cell.

As shown in FIG. 6 to FIG. 8, the bottom electrode such as a transparent electrode is formed on a surface of the substrate 50 through magnetron sputtering or a chemical method, the bottom electrode may be divided into a plurality of first electrode layers 51 through scribing, a gap between the plurality of first electrode layers 51 is a first hollowed-out portion P1, and a method for scribing may include laser scribing, masking, or exposure.

The central part 57 of the bottom electrode is removed, and the first hollowed-out portion P1 is formed through scribing, such that the plurality of first electrode layers 51 are separated from each other, and a risk of short circuit caused by direct contact between adjacent first electrode layers 51 is reduced. The central part 57 of the bottom electrode and the first hollowed-out portion P1 may or may not be filled with an insulating substance. The central part 57 refers to a geometrically central region with a radius of the bottom electrode.

A process of preparing the solar cell 5 is described by using an example in which the solar cell 5 includes four sub-cells 6. The substrate 50 of a circular structure is used as an example for description, in which, a piece of FTO transparent conductive glass is provided, and a laser beam is used to perform etching on the substrate 50 by taking the center of the substrate as the etching center to obtain a circular region with a radius, where the circular region constitutes the central part 57. Then, scribing is performed on the bottom electrode at 90°, to obtain four first hollowed-out portions P1, one end of each of the four first hollowed-out portions P1 is located at the edge of the circular reign, and the other ends are located at the outer edge of the substrate 50. The four first hollowed-out portions P1 divide the bottom electrode into four first electrode layers, so as to divide the solar cell into four sub-cells.

In S220, a photovoltaic conversion module is formed on a surface of the first electrode layer of each of the plurality of sub-cells that faces away from the substrate.

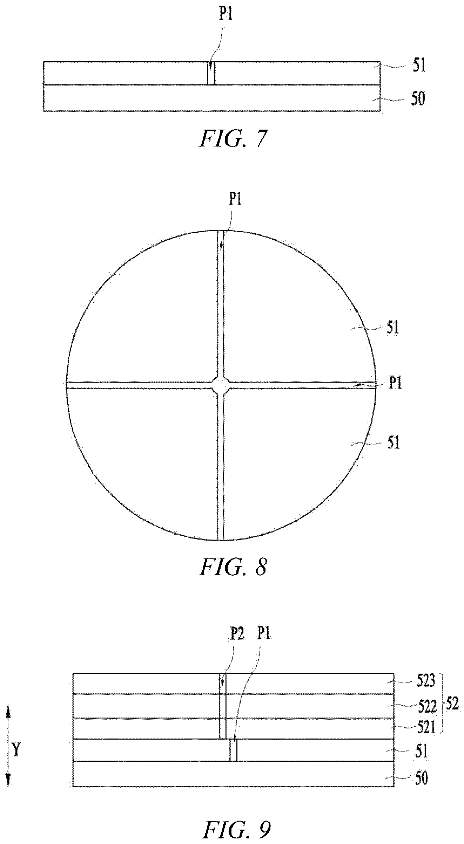

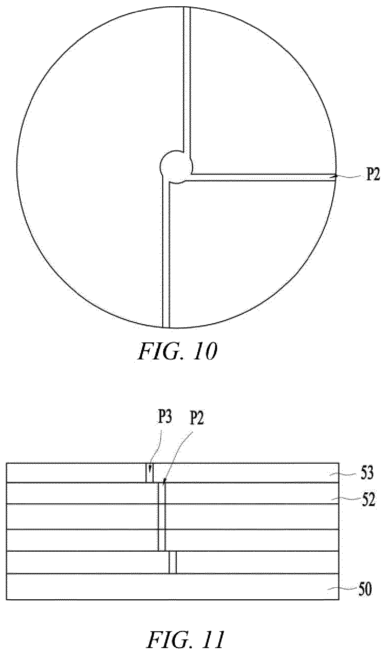

As shown in FIG. 9 and FIG. 10, the photovoltaic conversion module 52 includes a first charge transport layer 521 (an electron hole transport layer), a photovoltaic conversion layer 522, and a second charge transport layer 523 (an electron transport layer) that are sequentially stacked along a thickness direction Y of the photovoltaic conversion module.

The first charge transport layer 521 is formed, through magnetron sputtering, chemical deposition, atomic layer deposition (ALD), or coating, on a surface of the first electrode layer 51 that faces away from the substrate 50. The first hollowed-out portion P1 may be filled with an insulating material, and certainly, may alternatively be directly provided with the material of the first charge transport layer 521.

The photovoltaic conversion layer 522 is formed, through coating, spray coating, spin coating, evaporation, or chemical deposition, on a surface of the first charge transport layer 521 that faces away from the substrate 50.

The second charge transport layer 523 is formed, through magnetron sputtering, chemical deposition, atomic layer deposition (ALD), or coating, on a surface of the photovoltaic conversion layer 522 that faces away from the substrate 50.

The scribing is performed through laser scribing, masking, or exposure, such that the second hollowed-out portion P2 penetrating the first charge transport layer 521, the photovoltaic conversion layer 522, and the second charge transport layer 523 is formed in the first charge transport layer 521, the photovoltaic conversion layer 522, and the second charge transport layer 523.

The solar cell 5 includes a first cell, a second cell, a third cell, and a fourth cell that are sequentially connected in series, and the first cell and the fourth cell are respectively the head cell and the tail cell in the series connection. The second electrode layer of the first cell is connected to a first electrode lead, the first electrode layer 51 of the fourth cell is connected to a second electrode wire, and there is no need to connect the first cell and the fourth cell in series. To reduce a risk of short circuit due to direct connection between the four cells caused by series connection between the first cell and the fourth cell, when the second hollowed-out portion P2 is formed through scribing, the first cell may not include the second hollowed-out portion P2, or an insulating material may be provided in the second hollowed-out portion P2 of the first cell.

In S230, a top electrode is formed on a surface of the photovoltaic conversion module that faces away from the substrate, the top electrode including a plurality of second electrode layers disposed at intervals, and the first electrode layer of one of the plurality of sub-cells being configured to be electrically connected to the second electrode layer of another sub-cell, such that the plurality of sub-cells are electrically connected.

As shown in FIG. 11 to FIG. 13, the top electrode such as a metal electrode is formed, through magnetron sputtering, chemical deposition, atomic layer deposition (ALD), or coating, in the second hollowed-out portion P2 and on the surface of the photovoltaic conversion module 52 that faces away from the substrate 50. The metal electrode located in the second hollowed-out portion P2 implements series connection of adjacent sub-cells 6.

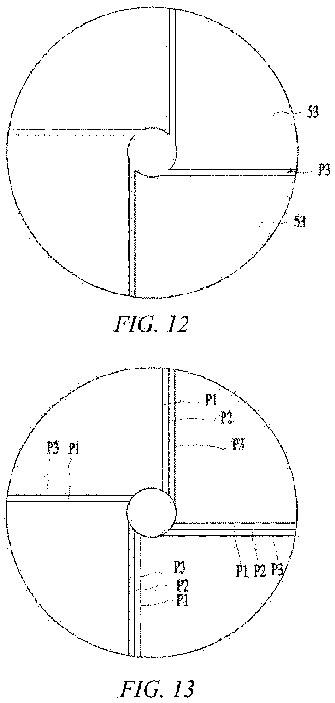

The scribing is performed through laser scribing, masking, or exposure, such that a third hollowed-out portion P3 is formed in the metal electrode and the photovoltaic conversion module 52, so as to divide the top electrode into a plurality of second electrode layers 53. In addition, a laser beam may be used at the center of the top electrode to fully separate the second electrode layers 53 from each other. FIG. 13 shows a structure of a dead region.

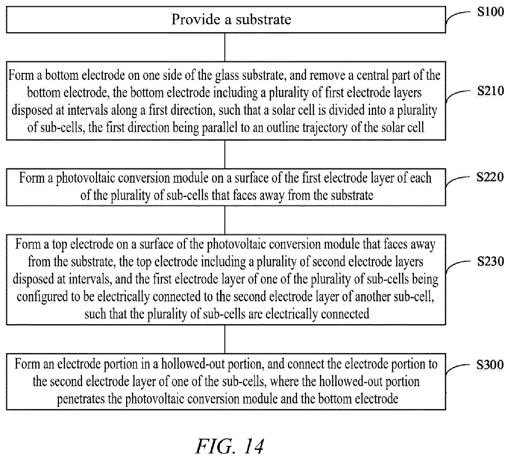

As shown in FIG. 14, in some embodiments, the following step is further included.

In S300, an electrode portion is formed in a hollowed-out portion, and the electrode portion is connected to the second electrode layer of one of the sub-cells, where the hollowed-out portion penetrates the photovoltaic conversion module and the bottom electrode.

To separate the sub-cells from each other, before the top electrode is formed, the step of forming the hollowed-out portion may be included, and the hollowed-out portion penetrates the photovoltaic conversion module and the bottom electrode. Then, the top electrode is formed on the surface of the photovoltaic conversion module that faces away from the substrate.

The hollowed-out portion may be empty and not filled with any insulating material, or filled with an insulating material; or may be filled with the material of the top electrode, and in this case, the material of the electrode portion is the same as that of the top electrode, and the electrode portion is connected to the second electrode layer of one of the sub-cells.

The electrode portion is formed in the hollowed-out portion, so that the space of the hollowed-out portion is fully utilized, an area of the dead region is reduced, and the solar cell can be supported and strengthened. In addition, an electrode lead may be connected to the electrode portion, so as to reduce an impact on other sub-cells caused in a process of disposing the electrode lead.

On a basis of the above steps, the first electrode wire and the second electrode wire may be welded through bonding using a conductive tape, ultrasonic welding, laser welding, or using a welding flux, and the first electrode wire and the second electrode wire constitute output electrodes. The first electrode wire may be connected to the electrode portion, or connected to the second electrode layer of the first cell, and the first electrode wire leads out carriers collected by the second electrode layer of the first cell. The second electrode wire may be connected to the first electrode layer of the fourth cell, and the second electrode wire is configured to lead out carriers collected by the first electrode layer of the fourth cell.

To facilitate connection between the first electrode layer of the fourth cell and the second electrode wire, edges of the photovoltaic conversion module and the second electrode layer of the fourth cell may be partially removed to expose the first electrode layer.

While the present application has been described with reference to the preferred embodiments, various modifications can be made, without departing from the scope of the appended claims. In particular, the technical features mentioned in the embodiments can be combined in any manner, as long as there is no structural conflict. The present application is not limited to the specific embodiments disclosed herein but includes all the technical solutions that fall within the scope of the claims.

## Claims

1. A solar cell (5), comprising a substrate (50) and a plurality of sub-cells (6) connected in series on the substrate (50), the plurality of sub-cells (6) being sequentially disposed along a first direction (X), wherein the first direction (X) is parallel to an outline trajectory of the substrate (50), wherein:
the outline trajectory of the substrate (50) refers to a shape of an outer contour of the substrate (50);the solar cell (5) comprises a hollowed-out portion (54), and the plurality of sub-cells (6) are sequentially arranged around the periphery of the hollowed-out portion (54),
each of the plurality of sub-cells (6) comprises a first electrode layer (51), a photovoltaic conversion module (52), and a second electrode layer (53) that are sequentially stacked along the thickness direction of the solar cell (5), the first electrode layer (51) is disposed between the substrate (50) and the photovoltaic conversion module (52), and the first electrode layer (51) of one of the plurality of sub-cells (6) is electrically connected to the second electrode layer (53) of another sub-cell (6), such that the plurality of sub-cells (6) are connected in series; and
the solar cell (5) comprises at least an electrode portion (55) located in the hollowed-out portion (54), and the electrode portion (55) is connected to the second electrode layer (53) of one of the sub-cells (6),
**characterised in that** at least part of the substrate has unequal thickness along the first direction such that at least part of the substrate (50) is of a curved surface structure.

2. The solar cell (5) according to claim 1, wherein
each of the plurality of sub-cells (6) comprises a power generation region (6a), the power generation regions (6a) have equal cross-sectional areas in a direction (Z) perpendicular to a thickness direction (Y) of the power generation regions, and the thickness direction (Y) is perpendicular to the first direction (X).

3. The solar cell (5) according to claim 1 or 2, wherein
the sub-cell (6) comprises a dead region, and an extension direction of the dead region, the first direction, and a thickness direction of the solar cell (5) are perpendicular to each other.

4. The solar cell (5) according to any one of claims 1 to 3, wherein
at least part of a cross section of the substrate (50) in a direction perpendicular to the thickness direction of the solar cell (5) is in an irregular shape, and the thickness direction is perpendicular to the first direction.

5. The solar cell (5) according to claim 4, wherein
the cross section of the substrate (50) in the direction perpendicular to the thickness direction of the solar cell (5) is circular or elliptical, and the plurality of sub-cells (6) are sequentially arranged along a circumferential direction of the substrate (50).

6. The solar cell (5) according to claim 5, wherein
the solar cell (5) comprises a first electrode wire (56), and the first electrode wire (56) is connected to the electrode portion (55).

7. The solar cell (5) according to claim 5 or 6, wherein
the photovoltaic conversion module (52) comprises a first charge transport layer (521), a photovoltaic conversion layer (522), and a second charge transport layer (523) that are sequentially stacked along a thickness direction of the sub-cell (6), and the first charge transport layer (521) is located between the first electrode layer (51) and the photovoltaic conversion layer (522);
the material of the first charge transport layer (521) comprises at least one of poly[bis(4-phenyl)(2,4,6-trimethylphenyl)amine (PTAA), poly(3,4-ethylenedioxythiophene) (PEDOT), nickel oxide (NiOx), CuI, and Cu₂O; and/or
the material of the photovoltaic conversion layer (522) conforms to the ABX₃ crystal structure, wherein A comprises at least one of methylammonium (MA), formamide (FA), and cesium (Cs), B comprises at least one of plumbum (Pb), stannum (Sn), and cuprum (Cu), and X comprises at least one of bromine (Br), chlorine (Cl), and iodine (I); and/or
the material of the second charge transport layer (523) comprises at least one of C60, stannic oxide (SnO₂), a fullerene derivative (PCBM), and titanium oxide (TiO₂).

8. The solar cell (5) according to any one of claims 5 to 7, wherein
the material of each of the first electrode layer (51) and the second electrode layer (53) is independently selected from aurum (Au), argentum (Ag), cuprum (Cu), aluminum (Al), a transparent conductive oxide (TCO), or carbon.

9. A photovoltaic module (2) comprising a plurality of solar cells (5) according to any one of claims 1 to 8.

10. A power consuming device comprising the photovoltaic module (2) according to claim 9, the photovoltaic module (2) being configured to provide electrical energy.

11. A method for preparing the solar cell (5) according to claim 1, comprising:
providing a substrate (50);
forming a bottom electrode on one side of the substrate (50), and removing a central part of the bottom electrode, the bottom electrode comprising a plurality of first electrode layers (51) disposed at intervals along a first direction, such that the solar cell (5) is divided into a plurality of sub-cells (6), the first direction being parallel to an outline trajectory of the solar cell (5), wherein at least part of the substrate has unequal thickness along the first direction such that at least part of the substrate (50) is of a curved surface structure;
forming a photovoltaic conversion module (52) on a surface of the first electrode layer (51) of each of the plurality of sub-cells (6) that faces away from the substrate (50); and
forming a top electrode on a surface of the photovoltaic conversion module (52) that faces away from the substrate (50), the top electrode comprising a plurality of second electrode layers (53) disposed at intervals, and the first electrode layer (51) of one of the plurality of sub-cells (6) being configured to be electrically connected to the second electrode layer (53) of another sub-cell (6), such that the plurality of sub-cells (6) are electrically connected.

12. The method for preparing a solar cell (5) according to claim 11, wherein
forming an electrode portion (55) in a hollowed-out portion (54), and connecting the electrode portion (55) to the second electrode layer (53) of one of the sub-cells (6), wherein the hollowed-out portion (54) penetrates the photovoltaic conversion module (52) and the bottom electrode.

## Patentansprüche

1. Solarzelle (5), umfassend ein Substrat (50) und eine Vielzahl von Subzellen (6), die auf dem Substrat (50) in Reihe geschaltet sind, wobei die Vielzahl von Subzellen (6) nacheinander entlang einer ersten Richtung (X) angeordnet sind, wobei die erste Richtung (X) parallel zu einer Umrissbahn des Substrats (50) ist, wobei:
die Umrissbahn des Substrats (50) sich auf eine Form einer Außenkontur des Substrats (50) bezieht; die Solarzelle (5) einen ausgehöhlten Abschnitt (54) umfasst und die Vielzahl von Subzellen (6) nacheinander um den Umfang des ausgehöhlten Abschnitts angeordnet sind,
jede der Vielzahl von Subzellen (6) eine erste Elektrodenschicht (51), ein fotovoltaisches Modul (52) und eine zweite Elektrodenschicht (53) umfasst, die nacheinander entlang der Dickenrichtung der Solarzelle (5) gestapelt sind, die erste Elektrodenschicht (51) zwischen dem Substrat (50) und dem fotovoltaischen Modul (52) angeordnet ist, und die erste Elektrodenschicht (51) einer der Vielzahl von Subzellen (6) elektrisch mit der zweiten Elektrodenschicht (53) einer anderen Subzelle (6) verbunden ist, so dass die Vielzahl von Subzellen (6) in Reihe geschaltet sind; und
die Solarzelle (5) mindestens einen Elektrodenabschnitt (55) umfasst, der sich in dem ausgehöhlten Abschnitt (54) befindet, und der Elektrodenabschnitt (55) mit der zweiten Elektrodenschicht (53) einer der Subzellen (6) verbunden ist, **dadurch gekennzeichnet, dass** mindestens ein Teil des Substrats eine ungleiche Dicke entlang der ersten Richtung aufweist, so dass mindestens ein Teil des Substrats (50) eine gekrümmte Oberflächenstruktur aufweist.

2. Solarzelle (5) nach Anspruch 1, wobei
jede der Vielzahl von Subzellen (6) eine Stromerzeugungsregion (6a) umfasst, die Stromerzeugungsregionen (6a) gleiche Querschnittsbereichen in einer Richtung (Z) senkrecht zu einer Dickenrichtung (Y) der Stromerzeugungsregionen aufweisen und die Dickenrichtung (Y) senkrecht zu der ersten Richtung (X) ist.

3. Solarzelle (5) nach Anspruch 1 oder 2, wobei
die Subzelle (6) eine tote Region umfasst, und eine Ausdehnungsrichtung der toten Region, die erste Richtung und eine Dickenrichtung der Solarzelle (5) senkrecht zueinander sind.

4. Solarzelle (5) nach einem der Ansprüche 1 bis 3, wobei
mindestens ein Teil eines Querschnitts des Substrats (50) in einer Richtung senkrecht zur Dickenrichtung der Solarzelle (5) eine unregelmäßige Form aufweist und die Dickenrichtung senkrecht zur ersten Richtung ist.

5. Solarzelle (5) nach Anspruch 4, wobei
der Querschnitt des Substrats (50) in der Richtung senkrecht zur Dickenrichtung der Solarzelle (5) kreisförmig oder elliptisch ist, und die Vielzahl von Subzellen (6) nacheinander entlang einer Umfangsrichtung des Substrats (50) angeordnet sind.

6. Solarzelle (5) nach Anspruch 5, wobei
die Solarzelle (5) einen ersten Elektrodendraht (56) umfasst, und der erste Elektrodendraht (56) mit dem Elektrodenabschnitt (55) verbunden ist.

7. Solarzelle (5) nach Anspruch 5 oder 6, wobei
das fotovoltaische Modul (52) eine erste Ladungstransportschicht (521), eine fotovoltaische Konversionsschicht (522) und eine zweite Ladungstransportschicht (523) umfasst, die nacheinander entlang einer Dickenrichtung der Subzelle (6) gestapelt sind, und sich die erste Ladungstransportschicht (521) zwischen der ersten Elektrodenschicht (51) und der fotovoltaischen Konversionsschicht (522) befindet;
das Material der ersten Ladungstransportschicht (521) mindestens eines von Poly[bis(4-phenyl)(2,4,6-trimethylphenyl)amin (PTAA), Poly(3,4-ethylendioxythiophen) (PEDOT), Nickeloxid (NiOx), Cul und CU₂O umfasst; und/oder das Material der fotovoltaischen Konversionsschicht (522) der ABX₃-Kristallstruktur entspricht, wobei A mindestens eines von Methylammonium (MA), Formamid (FA) und Cäsium (Cs) umfasst, B mindestens eines von Plumbum (Pb), Stannum (Sn) und Cuprum (Cu) umfasst und X mindestens eines von Brom (Br), Chlor (Cl) und Jod (I) umfasst; und/oder
das Material der zweiten Ladungstransportschicht (523) mindestens eines der von C60, Zinnoxid (SnO₂), ein Fullerenderivat (PCBM) und Titanoxid (TiO₂) umfasst.

8. Solarzelle (5) nach einem der Ansprüche 5 bis 7, wobei
das Material jeder der ersten Elektrodenschicht (51) und der zweiten Elektrodenschicht (53) unabhängig voneinander ausgewählt ist aus Aurum (Au), Argentum (Ag), Cuprum (Cu), Aluminium (Al), einem transparenten leitfähigen Oxid (TCO) oder Kohlenstoff.

9. Fotovoltaisches Modul (2), umfassend eine Vielzahl von Solarzellen (5) nach einem der Ansprüche 1 bis 8.

10. Stromverbrauchende Vorrichtung, umfassend das fotovoltaische Modul (2) nach Anspruch 9,
wobei das fotovoltaische Modul (2) konfiguriert ist, um elektrische Energie bereitzustellen.

11. Verfahren zum Herstellen der Solarzelle (5) nach Anspruch 1, umfassend:
Bereitstellen eines Substrats (50);
Ausbilden einer unteren Elektrode auf einer Seite des Substrats (50) und Entfernen eines zentralen Teils der unteren Elektrode, wobei die untere Elektrode eine Vielzahl von ersten Elektrodenschichten (51) umfasst, die in Abständen entlang einer ersten Richtung angeordnet sind, so dass die Solarzelle (5) in eine Vielzahl von Subzellen (6) unterteilt ist, wobei die erste Richtung parallel zu einer Umrissbahn der Solarzelle (5) ist, wobei mindestens ein Teil des Substrats eine ungleiche Dicke entlang der ersten Richtung aufweist, so dass mindestens ein Teil des Substrats (50) eine gekrümmte Oberflächenstruktur aufweist;
Ausbilden eines fotovoltaischen Moduls (52) auf einer Oberfläche der ersten Elektrodenschicht (51) jeder der Vielzahl von Subzellen (6), die von dem Substrat (50) abgewandt ist; und
Ausbilden einer oberen Elektrode auf einer Oberfläche des fotovoltaischen Moduls (52), die von dem Substrat (50) abgewandt ist, wobei die obere Elektrode eine Vielzahl von zweiten Elektrodenschichten (53) umfasst, die in Abständen angeordnet sind, und wobei die erste Elektrodenschicht (51) einer der Vielzahl von Subzellen (6) konfiguriert ist, um mit der zweiten Elektrodenschicht (53) einer anderen Subzelle (6) elektrisch verbunden zu sein, so dass die Vielzahl von Subzellen (6) elektrisch verbunden sind.

12. Verfahren zum Herstellen einer Solarzelle (5) nach Anspruch 11, wobei Ausbilden eines Elektrodenabschnitts (55) in einem ausgehöhlten Abschnitt (54) und Verbinden des Elektrodenabschnitts (55) mit der zweiten Elektrodenschicht (53) einer der Subzellen (6), wobei der ausgehöhlte Abschnitt (54) das fotovoltaische Modul (52) und die untere Elektrode durchdringt.

## Revendications

1. Cellule solaire (5), comprenant un substrat (50) et une pluralité de sous-cellules (6) connectées en série sur le substrat (50), la pluralité de sous-cellules (6) étant séquentiellement disposées le long d'une première direction (X), la première direction (X) étant parallèle à une trajectoire de contour du substrat (50), dans laquelle :
la trajectoire de contour du substrat (50) fait référence à une forme d'un contour externe du substrat (50) ; la cellule solaire (5) comprend une partie évidée (54), et la pluralité de sous-cellules (6) sont séquentiellement agencées autour de la périphérie de la partie évidée (54),
chacune de la pluralité de sous-cellules (6) comprend une première couche d'électrode (51), un module de conversion photovoltaïque (52), et une deuxième couche d'électrode (53) qui sont séquentiellement empilés le long de la direction de l'épaisseur de la cellule solaire (5), la première couche d'électrode (51) est disposée entre le substrat (50) et le module de conversion photovoltaïque (52), et la première couche d'électrode (51) de l'une de la pluralité de sous-cellules (6) est électriquement connectée à la deuxième couche d'électrode (53) d'une autre sous-cellule (6), de telle sorte que la pluralité de sous-cellules (6) soient connectées en série ; et
la cellule solaire (5) comprend au moins une partie électrode (55) située dans la partie évidée (54), et la partie électrode (55) est connectée à la deuxième couche d'électrode (53) de l'une des sous-cellules (6),
**caractérisée en ce qu'**au moins une partie du substrat a une épaisseur inégale le long de la première direction de telle sorte qu'au moins une partie du substrat (50) soit d'une structure de surface courbe.

2. Cellule solaire (5) selon la revendication 1, dans laquelle
chacune de la pluralité de sous-cellules (6) comprend une région de génération d'énergie (6a), les régions de génération d'énergie (6a) ont des aires égales en section transversale dans une direction (Z) perpendiculaire à une direction d'épaisseur (Y) des régions de génération d'énergie, et la direction de l'épaisseur (Y) est perpendiculaire à la première direction (X).

3. Cellule solaire (5) selon la revendication 1 ou 2, dans laquelle
la sous-cellule (6) comprend une région morte, et une direction d'extension de la région morte, la première direction et une direction de l'épaisseur de la cellule solaire (5) sont perpendiculaires les unes aux autres.

4. Cellule solaire (5) selon l'une quelconque des revendications 1 à 3, dans laquelle
au moins une partie d'une section transversale du substrat (50) dans une direction perpendiculaire à la direction de l'épaisseur de la cellule solaire (5) est de forme irrégulière, et la direction de l'épaisseur est perpendiculaire à la première direction.

5. Cellule solaire (5) selon la revendication 4, dans laquelle
la section transversale du substrat (50) dans la direction perpendiculaire à la direction de l'épaisseur de la cellule solaire (5) est circulaire ou elliptique, et la pluralité de cellules solaires (6) sont séquentiellement agencées le long d'une direction circonférentielle du substrat (50).

6. Cellule solaire (5) selon la revendication 5, la cellule solaire (5) comprenant un premier fil d'électrode (56), et le premier fil d'électrode (56) est relié à la partie électrode (55).

7. Cellule solaire (5) selon la revendication 5 ou 6, dans laquelle
le module de conversion photovoltaïque (52) comprend une première couche de transport de charges (521), une couche de conversion photovoltaïque (522), et une deuxième couche de transport de charges (523) qui sont séquentiellement empilées le long d'une direction de l'épaisseur de la sous-cellule (6), et la première couche de transport de charges (521) est située entre la première couche d'électrode (51) et la couche de conversion photovoltaïque (522) ;
le matériau de la première couche de transport de charges (521) comprend au moins l'un du poly[bis(4-phényl)(2,4,6-triméthylphényl)amine (PTAA), du poly(3,4-éthylènedioxythiophène) (PEDOT), de l'oxyde de nickel (NiOx), du CuI, et du Cu₂O ; et/ou
le matériau de la couche de conversion photovoltaïque (522) se conforme à une structure cristalline ABX₃, A comprenant au moins l'un du méthylammonium (MA), du formamide (FA) et du césium (Cs), B comprenant au moins l'un du plomb (Pb), de l'étain (Sn) et du cuivre (Cu), et X comprend au moins l'un du brome (Br), du chlore (Cl) et de l'iode (I) ; et/ou
le matériau de la deuxième couche de transport de charges (523) comprend au moins l'un du C60, de l'oxyde d'étain (SnO₂), d'un dérivé du fullerène (PCBM), et de l'oxyde de titane (TiO₂).

8. Cellule solaire (5) selon l'une quelconque des revendications 5 à 7, dans laquelle
le matériau de chacune de la première couche d'électrode (51) et la deuxième couche d'électrode (53) est indépendamment choisi parmi l'or (Au), l'argent (Ag), le cuivre (Cu), l'aluminium (Al), un oxyde conducteur transparent (TCO), ou le carbone.

9. Module photovoltaïque (2) comprenant une pluralité de cellules solaires (5) selon l'une quelconque des revendications 1 à 8.

10. Dispositif de consommation d'énergie comprenant le module photovoltaïque (2) selon la revendication 9,
le module photovoltaïque (2) étant conçu pour fournir de l'énergie électrique.

11. Procédé de préparation de la cellule solaire (5) comprenant la revendication 1, comprenant les étapes consistant à :
fournir un substrat (50) ;
former une électrode de fond sur un côté du substrat (50), et retirer une partie centrale de l'électrode de fond, l'électrode de fond comprenant une pluralité de premières couches d'électrode (51) disposées à des intervalles le long d'une première direction, de telle sorte que la cellule solaire (5) soit divisée en une pluralité de sous-cellules (6), la première direction étant parallèle à une trajectoire de contour de la cellule solaire (5), au moins une partie du substrat ayant une épaisseur inégale le long de la première direction de telle sorte qu'au moins une partie du substrat (50) soit d'une structure de surface courbe ;
former un module de conversion photovoltaïque (52) sur une surface de la première couche d'électrode (51) de chacune de la pluralité de sous-cellules (6) qui fait face à l'opposé du substrat (50) ; et
former une électrode supérieure sur une surface du module de conversion photovoltaïque (52) qui fait face à l'opposé du substrat (50), l'électrode supérieure comprenant une pluralité de deuxièmes couches d'électrode (53) disposées à des intervalles, et la première couche d'électrode (51) de l'une de la pluralité de sous-cellules (6) étant conçue pour être électriquement connectée à la deuxième couche d'électrode (53) d'une autre sous-cellule (6), de telle sorte que la pluralité de sous-cellules (6) soient électriquement connectées.

12. Procédé de préparation d'une cellule solaire (5) selon la revendication 11, dans lequel :
former une partie électrode (55) dans une partie évidée (54), et connecter la partie électrode (55) à la deuxième couche d'électrode (53) de l'une des sous-cellules (6), la partie évidée (54) pénétrant dans le module de conversion photovoltaïque (52) et l'électrode de fond.
